## Europäisches Patentamt

(19) **European Patent Office**

**Office européen des brevets**

(11) Publication number: **0 031 448**
**B1**

(12) # EUROPEAN PATENT SPECIFICATION

(45) Date of publication of patent specification: **11.05.83**

(51) Int. Cl.³: **H 01 L 23/42** //H01L23/46

(21) Application number: **80107222.4**

(22) Date of filing: **20.11.80**

(54) Thermal conduction module for integrated circuit chips.

(30) Priority: **17.12.79 US 104635**

(43) Date of publication of application:
**08.07.81 Bulletin 81/27**

(45) Publication of the grant of the patent:
**11.05.83 Bulletin 83/19**

(84) Designated Contracting States:
**DE FR GB**

(56) References cited:
**US - A - 4 226 281**

**IBM TECHNICAL DISCLOSURE BULLETIN, vol. 22, no. 6, November 1979 New York, USA A. J. ARNOLD: "Structure for the removal of heat from an integrated circuit module", pages 2294—2296.**
**IBM TECHNICAL DISCLOSURE BULLETIN, vol. 21, no. 2, July 1978, New York, USA R. C. CHU "Conduction cooling", pages 752—753.**

(73) Proprietor: **International Business Machines Corporation**
**Armonk, N.Y. 10504 (US)**

(72) Inventor: **Gupta, Omkarnath Ramnath**
**1361 South West First Street**
**Boca Raton Florida 33432 (US)**

(74) Representative: **Richards, John Peter**
**IBM UNITED KINGDOM PATENT OPERATIONS**
**Hursley Park**
**Winchester Hants, SO21 2JN (GB)**

(56) References cited:
**IBM TECHNICAL DISCLOSURE BULLETIN, vol. 19, no. 12, May 1977, New York, USA H. C. KAMMERER: "Thermal conduction button", pages 4622—23.**
**IBM TECHNICAL DISCLOSURE BULLETIN, vol. 23, no. 1, June 1980, New York, USA J. C. HASSON et al. "Pistons for cooling circuit chip", pages 189—190.**

Courier Press, Leamington Spa, England.

Thermal conduction module for integrated circuit chips

This invention relates to a thermal conduction module for integrated circuit chips.

In connection with integrated circuit chip thermal conduction modules, it is necessary to remove the heat generated by the circuitry on the chips to a heat sink, such as cold plate which has cooling fluid continually circulating therethrough. Improving the heat conduction path from the chip to the heat sink not only allows a higher power chip to be utilized, but alternatively allows a simpler heat sink to be used. For example, a heat sink comprising heat dissipating fins located in a forced air stream can be used to replace the more complicated cold plate.

With the miniaturized capabilities afforded by solid state electronics, various improved means of dissipating the heat generated by solid state components has been investigated. The standard for forced convection means appears to have reached its limit of practicality in that the amount of air that is required to provide sufficient cooling to the limited heat dissipating surfaces introduces a noise problem, and without some auxiliary technique cannot maintain each of a large number of components within its critical, narrow operating temperature range. Accordingly, especially in connection with large scale computer systems, various innovative cooling systems have been devised. One of the more recent systems investigated has been the gas encapsulated cooling module of U.S. Patent 3,993,123, wherein a thermal conduction module is provided which utilizes inert gas having good thermal conductivity as the encapsulated medium in combination with a conductive heat transfer arrangement. The integrated circuit chips to be cooled in the system are reverse mounted by connecting them face down to a substrate through solder balls. Because of this type of mounting, the chip is often slightly tilted. The tilt results in a poor surface contact between a conductive stud element which is intended to conduct heat away from the chip and the back side of the chip. Such tilt also results in a poor surface contact between the stud and an opening in a thermally conductive housing in which the stud is located. Accordingly, a high thermal resistance path is formed which required the insertion of a thermally conductive gas to lower the thermal resistance. However, this did not completely solve the problem.

Thus it is an object of this invention to provide an improvement in the thermal conduction module of the kind disclosed in U.S. Patent 3,993,123.

Accordingly, the present invention provides a thermal conduction module for conducting heat from a plurality of integrated circuit chips located therein, the module comprising a substrate on which the chips are mounted, a housing made of heat conductive material sealed to the substrate and forming a cap over the chips, a plurality of elongated openings in the inner surface of the housing each facing a respective chip, the longitudinal axis of each opening being at least approximately perpendicular to the respective chip, characterised in that each opening contains a plurality of independently movable heat conductive elements each spring biassed into contact with the respective chip by spring means and being movable longitudinally of the opening, and in that further spring means are located between the heat conductive elements in each of the openings forcing them mutually away from one another and into contact with the wall of the opening.

The invention provides greatly improved cooling characteristics of the chips, as will be discussed more fully hereinafter.

Embodiments of the invention will now be described with reference to the accompanying drawings, wherein:—

Fig. 1 is a partial cross-sectional view of a first embodiment of a thermal conduction module having four studs in each cylindrical opening spring loaded against the associated chip;

Fig. 2 is a partial section taken along the line 2—2 of Fig. 1;

Fig. 3 is a schematic plan view of a prior art stud in the cylindrical opening of a thermal conduction module;

Fig. 4 is an enlarged cross-sectional view through a prior art stud in a thermal conduction module;

Fig. 5 is a schematic plan view of six studs in a cylindrical opening of a thermal conduction module;

Fig. 6 is a cross-section of the six stud arrangement taken along the line 6—6 of Fig. 5;

Fig. 7 is a schematic representation of a crown spring with multiple springlets, one for each stud in the cylindrical opening of a thermal conduction module;

Fig. 8 is an enlarged view of a single stud showing the side springlet in detail; and

Fig. 9 is a schematic partial cross-sectional plan view of a six stud arrangement showing the springlets therebetween.

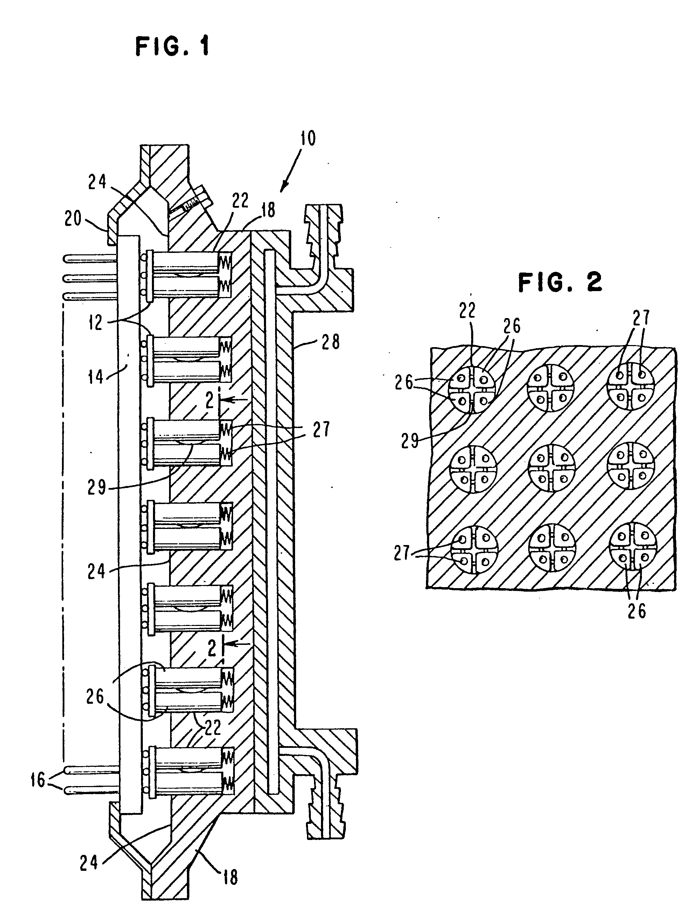

Referring to Fig. 1, there is shown a partial cross-sectional view of a thermal conduction module 10 for conducting heat removal from a plurality of semiconductor integrated circuit chips 12 contained therein. As is well known, such a chip consists of densely packed solid state circuits and devices, and the power consumed in the circuits within the chip generates heat which must be removed from the chip.

The chips 12 are mounted on one side of a substrate 14, typically made of ceramic material, which has pins 16 extending from the other side thereof. These connecting pins 16 permit plugging the module into a board (not shown) which may carry auxiliary circuits. A housing or cap 18 is hermetically sealed to the substrate 14 by means of a flange 20 which extends from the periphery of the substrate 14 to the cap 18. The cap 18 is made of a good heat conductive material such as copper or aluminium. The inner surface 24 of the cap 18 contains a plurality of cylindrical openings 22 each facing a respective chip with the longitudinal axis of each opening being nominally perpendicular to the chip. Fig. 2 shows nine such openings 22 each containing four heat conductive elements or studs 26 which are independently movable longitudinally of the opening. The stud elements 26 can take various shapes, but in the present case the preferred shape is that of a segment of a cylinder, since this shape provides that by far the major part of the cross-sectional area of the opening is occupied by the elements, whose curved outer sides collectively conform to the cylindrical wall of the opening. The studs 26 are made of copper or aluminium or an alloy thereof for good heat conducting properties. The number of studs 26 in each opening 22 is dependent upon a number of factors such as the amount of power consumed by the associated chip and the difficulty in manufacturing and assembly. It should be appreciated, however, that the object is to contact as much of the chip 12 surface as is practically possible with the studs 26. Accordingly, if there are a large number of studs 26 contacting the surface, the lateral dimensions of the studs 26 will have to be relatively small to be included in the cylindrical opening 22 in the housing 18 adjacent the chip surface. Similarly, if fewer studs 26 are utilized in each cylindrical opening 22, the size can be increased accordingly.

Each stud is individually spring loaded by a spring 27 so as to exert a predetermined force against the surface of the associated chip 12. The springs 27 are compressed against the inner end of the opening and the inner end of each stud 26, thereby providing a longitudinal force on the studs biasing them lengthwise partially out of the opening into contact with the associated chip. Further spring means in the form of a plurality of leaf springs 29, each located between a respective adjacent pair of the studs 26 within the opening 22, force the studs 26 mutually apart and into good thermal contact with the cylindrical wall of the opening 22.

The thermal conduction module 10 shown in Fig. 1 includes a cold plate 28 attached to the housing 18 which is the eventual heat sink for the heat from the chips. However, the multiple studs 26 increase the efficiency of heat transfer from the chips 12 sufficiently that a finned air cooling heat sink arrangement would be operable therewith for chips of normal power consumption. Alternatively, because of the increased heat removal capabilities, the multiple studs 26 allow the use of higher power chips 12.

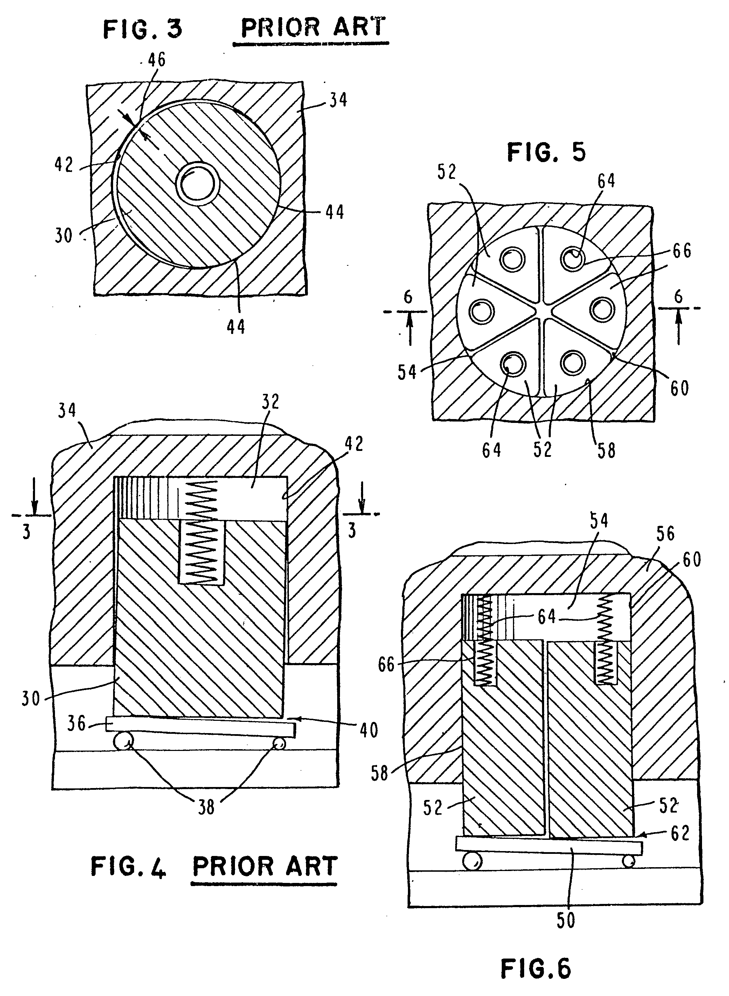

Figs. 3 and 4 illustrate the prior art arrangement of U.S. Patent 3,993,123 using a single stud 30 located in each cylindrical opening 32 in a housing 34 and spring loaded against a chip 36. The tilt of the chip in Fig. 4 is considerably exaggerated for purposes of illustration. Chips 36 mounted on solder ball connectors 38, as shown in Fig. 4, have a tendency to be slightly tilted as a result of this type of mounting. The prior art one piece stud 30 extending from the cylindrical opening 32 in the housing 34 will contact the chip 36 at the highest point thereof. As can be seen in Fig. 4, this creates a large gap 40 between the stud 30 and the chip 36 which is ordinarily filled with air. Also, the one piece stud 30 makes contact with the cylindrical wall 42 of the opening 32 in which it is located at only one or two places 44 with the rest of the circumference of the stud 30 forming an annular gap 46 (Fig. 3) with the cylindrical wall 42 of the opening 30, which is also ordinarily filled with air. Air is a well known good thermal insulator which provides a high thermal resistance in the gaps 40 and 46 thereby restricting the heat removal ability of the module. A number of solutions have been proposed to solve this problem. For example, the module has been filled with helium gas which fills the gaps 40 and 46 so as to lower the thermal resistance, since helium gas is a much better heat conductor than air. This solution, however, introduced problems of containing the helium gas for the necessary length of time, since it is a highly permeable fluid. It has also been proposed that the end of the stud contacting the chip be outwardly curved or dished, thereby giving a predetermined area contact between the stud and the chip regardless of the chip tilt. However, the chip is still only contacted at one small localised area.

Figs. 5 to 9 illustrate in relation to one embodiment of the invention how the heat transfer from the chip may be improved, permitting air to be used for the gas filling of the module if desired, although it is to be understood that the invention does not preclude the use of helium or other thermal conductive gas as a gas filling if desired. Furthermore, Figs. 5 to 9 only show details of a single opening and associated set of studs for the cap of the module, and it is to be understood that a number of such openings and sets of studs are provided as shown in Figs. 1 and 2, the only difference being that in Figs. 5 to 9 there are six studs per opening whereas in Figs. 1 and 2 there are four studs per opening. In Fig. 6 the tilt of the chip 50 is somewhat exaggerated to better illustrate the operation of the embodiment of the invention. A plurality of studs 52 are located in a cylindrical opening 54 in the module housing or cap 56. As can be seen in Fig. 5, there are six studs 52 in the form of cylinder segments located in each cylindrical housing opening 54 within the module. The outer side of each stud 52, that is, the surface 58 opposite the inner pointed end, is curved with a similar curvature to that of the cylinder wall 60. As shown in the cross-sectional diagram of Fig. 6, each stud 52 makes at least a point contact with the chip 50 regardless of the tilt. There are now six areas or points of contact. It can be seen from Fig. 6 that the six points of contact not only improve direct the thermal conduction from the chip 50, but also reduce the size of the gaps 62, thereby further lowering the thermal resistance. This arrangement also has the advantage of distributing the points where contact is made across the surface of the chip 50. This considerably reduces the temperature differential in the chip, thereby reducing stresses in the chip.

Each of the studs 52 within a cylindrical opening 54 is individually spring loaded outwardly from the cylindrical opening 54 to provide a positive contact with the chip 50. The springs 64 not only hold the studs 52 in place against the associated chip surface, but provide a positive force of the stud 52 against the chip 50, which force has been found to enhance the heat transfer from the chip 50 to the stud 52. The spring 64 may be of the coil type, with one end thereof inserted in a cylindrical opening 66 provided in the top of each stud 52. The other end of the spring 64 bears against the inner end of the cylindrical opening 54 in the housing 56, thereby providing sufficient compression of the spring 64 when the stud 52 is in place to provide the desired outward force on the stud. Since each stud 52 is free to move individually, the individual spring force provides the individual contacting force of each stud 52 against the chip 50.

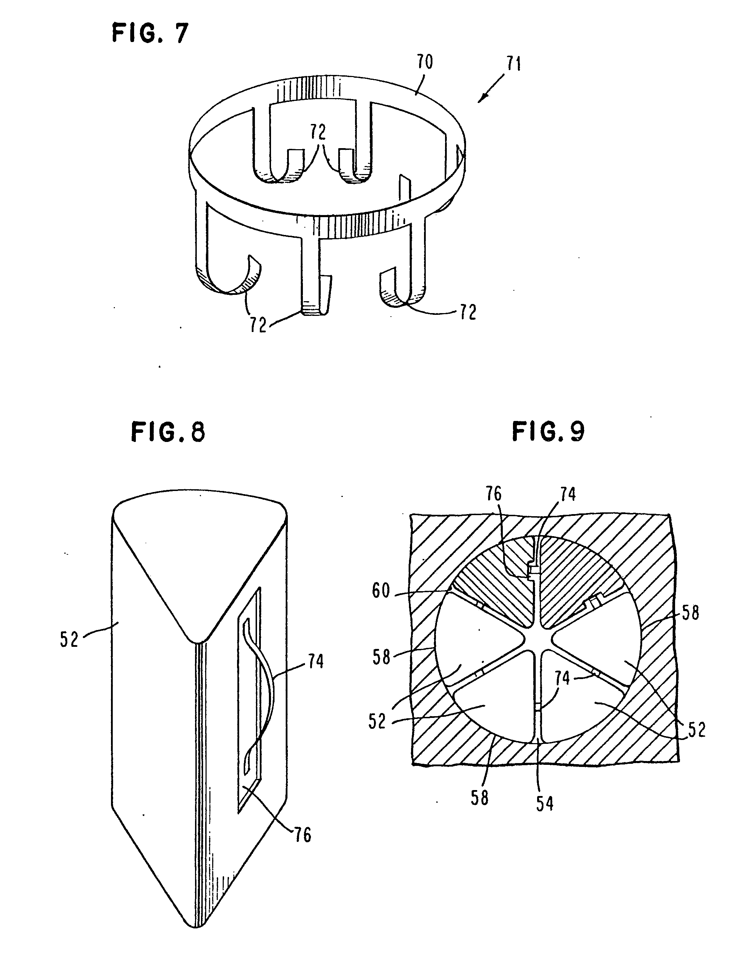

An alternative spring 71 for the individual studs is shown in Fig. 7. The arrangement is known as a crown spring 71 which consists of a band 70 with the appropriate number of springlets 72 or curved portions made of spring material, such that each spring material portion 72 bears against the inner end of a respective one of the studs 52. Thus, the number of studs 52 determines the number of springlets 72. The crown spring 71 is inserted into the cylindrical opening 54 with the band 70 side first so that the springlets 72 extend away from the inner end of the cylindrical opening 54 to provide the required spring force for each stud 52. The main advantage of this type spring lies mainly in the ease of assembly over against the handling of a number of individual springs 64.

An enlarged view of one of the studs 52 showing a side mounted leaf spring or springlet 74 is shown in Fig. 8. An indented groove 76 is located lengthwise along one side of the stud. The ends of the springlet 74 are attached to the bottom of the groove 76 at the appropriate distance from one another to provide the required bowing of the springlet. The springlet 74 consists of a strip of spring material of sufficient resiliency to provide a small outward force from the side of the stud 52 from which the springlet extends.

Fig. 9 is an enlarged plan view in partial section of the set of studs 52 in the opening 54. Each of the springlets 74 extending from the side of a stud 52 will, when assembled, provide a force against the adjacent stud, which force causes the outer curved surface 58 of the stud 52 to make good contact with the cylindrical wall 60 of the opening 54 containing the studs. As was mentioned above, a contacting force at the contact area between two surfaces enhances the thermal conductivity thereof. Accordingly, the springlets 74 on the side of each stud 52, when assembled, forces the studs mutually outwardly and causes each of the studs 52 to make at least line contact with the cylindrical wall 60 of the opening 54. It should be appreciated that six areas of contact are provided, thereby considerably reducing the annulus gap 46 (Fig. 3). This considerably reduces the thermal resistance of the gap or interface between the studs 52 and the cylindrical wall 60 of the housing opening 54. The springlets 74 under severe pressure could fit entirely within the groove 76 in the side wall of the stud 52. However, this kind of pressure is not contemplated. The essentially spring suspension of the studs 52 relative to one another within the cylindrical opening 54 reduces the friction between the stud side walls providing easier lengthwise motion of the individual studs 52 so as to limit the end spring 64 force required to provide the force holding the studs 52 against the chip 50.

It is to be understood that various heat transfer enhancement techniques can be applied to the module 10 such as outwardly curving or dishing the ends of the studs which contact the chip, and filling the interfaces between the chip and the studs and the studs and the cylindrical walls of the housing with a good heat conducting material, such as helium, dielectric liquid, grease, or wax. It is also to be understood that a common central spring means can be used in place of the individual leaf springs 74 to force the studs 52 mutually outwardly.

## Claims

1. A thermal conduction module for conducting heat from a plurality of integrated circuit chips located therein, the module comprising a substrate (14) on which the chips (12) are mounted, a housing (18) made of heat conductive material sealed to the substrate and forming a cap over the chips, a plurality of elongated openings (22) in the inner surface of the housing each facing a respective chip, the longitudinal axis of each opening being at least approximately perpendicular to the respective chip, characterised in that each opening (22) contains a plurality of independently movable heat conductive elements (26) each biassed into contact with the respective chip (12) by spring means (27) and being movable longitudinally of the opening, and in that further spring means (29) are located between the heat conductive elements in each of the openings forcing them mutually away from one another and into contact with the wall of the opening.

2. A thermal conduction module according to claim 1, wherein the heat conductive elements occupy the major part of the cross-sectional area of the opening and have outer sides which collectively conform to the shape of the wall of the opening.

3. A thermal conduction module according to claim 2, wherein each opening is cylindrical and the heat conductive elements are segments of a cylinder.

4. A thermal conduction module according to any preceding claim, wherein the first mentioned spring means comprises individual coil springs each applying an outward force to an associated heat conductive element away from the inner end of the opening.

5. A thermal conduction module according to any one of claims 1 to 3, wherein the first mentioned spring means is a crown spring having a number of springlets extending therefrom, each springlet being in contact with the inner end of an associated heat conductive element.

6. A thermal conduction module according to any preceding claim, wherein the further spring means comprises a plurality of bowed pieces of spring material each disposed between a respective adjacent pair of heat conductive elements.

**Patentansprüche**

1. Wärmeleitender Modul zur Wärmeableitung von einer Mehrzahl darauf angeordneter integrierter Schaltungs-Chips, mit einem Substrat (14), auf dem die Chips (12) befestigt sind, mit einem Gehäuse (18) aus wärmeleitendem Werkstoff, das auf dem Substrat abgedichtet angebracht ist und eine Kappe über den Chips bildet, mit einer Anzahl Längsöffnungen (22) in der Innenfläche des Gehäuses, von denen jede einem Chip zugeordnet ist und deren Längsachse zumindest nahezu senkrecht zu dem betreffenden Chip verläuft, dadurch gekennzeichnet, daß jede Öffnung (22) eine Anzahl unabhängig voneinander beweglicher Wärmeleitelemente (26) aufweist, von denen jedes mittels Federn (27) in Kontakt an dem betreffenden Chip (12) anliegt und in der Öffnung längsbeweglich ist, und daß weitere Federelemente (29) zwischen den Wärmeleitelementen in jeder der Öffnungen angeordnet sind, welche dieselben gegenseitig voneinander weg und in Kontakt mit der Wand der Öffnung drücken.

2. Wärmeleitender Modul nach Anspruch 1, dadurch gekennzeichnet, daß die Wärmeleitelemente den überwiegenden Teil der Querschnittsfläche der Öffnung einnehmen und Außenseiten aufweisen, die gemeinsam der Form der Wand der Öffnung angepaßt sind.

3. Wärmeleitender Modul nach Anspruch 2, dadurch gekennzeichnet, daß jede Öffnung zylindrisch ist und die Wärmeleitelemente Segmente eines Zylinders bilden.

4. Wärmeleitender Modul nach einem der vorhergehenden Ansprüche, dadurch gekennzeichnet, daß die zuerst genannten Federn einzelne Schraubenfedern aufweisen, von denen jede eine nach außen vom inneren Ende der Öffnung weg gerichtete Kraft auf ein zugeordnetes Wärmeleitelement ausübt.

5. Wärmeleitender Modul nach einem der Ansprüche 1 bis 3, dadurch gekennzeichnet, daß die zuerst genannten Federn als Kronfedern mit einer Anzahl herausragender Federfinger ausgebildet sind, wobei jeder Federfinger in Kontakt mit dem inneren Ende des zugeordneten Wärmeleitelements steht.

6. Wärmeleitender Modul nach einem der vorhergehenden Ansprüche, dadurch gekennzeichnet, daß die weiteren Federelemente eine Anzahl abgebogener Federstücke aufweisen, die jedes zwischen einem entsprechenden angrenzenden Paar Wärmeleitelementen angeordnet sind.

**Revendications**

1. Un module thermo conducteur pour assurer la conduction thermique à partir de plusieurs microplaquettes à circuits intégrés disposées dans celui-çi, le module comprenant un substrat (14) sur lequel sont montées les microplaquettes (12), un boitier (18) en matériau thermo-conducteur fixé hermétiquement au substrat et formant un capot sur les microplaquettes, plusieurs ouvertures allongées (22) ménagées dans la surface intérieure du boitier, chacune d'elles faisant face à une microplaquette respective, l'axe longitudinal de chaque overture étant au moins approximativement perpendiculaire à la microplaquette respective, caractérisé en ce que chaque ouverture (22) contient plusieurs éléments thermo-conducteurs (26) indépendamment mobiles chacun étant mis en contact avec la microplaquette respective (12) sous l'action d'un moyen à ressort (27), et chacun étant longitudinalement mobiles dans l'ouverture, et en ce que d'autres moyens à ressort (29) sont disposés entre les éléments thermo-conducteurs dans chacune des ouvertures, les écartant mutuellement les uns des autres et les appliquant contre la paroi de l'ouverture.

2. Un module thermo-conducteur selon la revendication 1 dans lequel les éléments thermo-conducteurs occupent la majeur partie de la section droite de l'ouverture et présentent des côtés extérieurs qui sont collectivement conformes à la forme de la paroi de l'ouverture.

3. Un module thermo-conducteur selon la revendication 2, dans lequel chaque ouverture est cylindrique et les éléments thermo-conducteurs sont des segments d'un cylindre.

4. Un module thermo-conducteur selon l'une quelconque des revendications précédentes, dans lequel le moyen à ressorts (27) cité en premier, comprend des ressorts helicoïdaux individuels appliquant chacun une force dirigée vers l'extérieur à un élément thermo-conducteur associé pour l'écarter de l'extrémité intérieure de l'ouverture.

5. Un module thermo-conducteur selon l'une quelconque des revendications 1 à 3, dans lequel le moyen à ressorts cité en premier est un ressort en couronne présentant un certain nombre de lames flexibles chacune en contact avec l'extrémité intérieure d'un élément thermo-conducteur associé.

6. Un module thermo-conducteur selon l'une quelconque des revendications précédentes dans lequel les autres moyens à ressorts comprennent plusieurs lames flexibles incurvées disposées chacune entre une paire adjacent respective d'éléments thermo-conducteurs.

**FIG. 1**

**FIG. 2**

FIG. 3   <u>PRIOR ART</u>

FIG. 5

FIG. 4   <u>PRIOR ART</u>

FIG.6

**FIG. 7**

**FIG. 8**

**FIG. 9**